# EUROPEAN PATENT SPECIFICATION

(11) **EP 1 852 468 B1**
(45) Date of publication and mention of the grant of the patent: **05.08.2009**
(21) Application number: 07251830.1
(22) Date of filing: 01.05.2007
(51) Int. Cl.: C08L 83/04

(54) **Method of forming a flux resistant silicone gel**
Verfahren zur Herstellung eines flussmittelbeständigen Silikongels
Procédé de formation d'un gel de silicone résistant au flux de soudure

(30) Priority: 02.05.2006 JP 2006128537
(43) Date of publication of application: 07.11.2007
(73) Proprietor: Shin-Etsu Chemical Co., Ltd., Tokyo (JP)
(72) Inventor: Ikeno, Masayuki, Annaka-shi, Gunma-ken (JP); Tanaka, Miyuki, Annaka-shi, Gunma-ken (JP); Sato, Kazuyasu, Annaka-shi, Gunma-ken (JP)
(74) Representative: Hallybone, Huw George

(56) References cited:
- EP-A- 1 475 069
- EP-A2- 0 471 475
- JP-A- 8 053 622
- US-A- 5 599 894

## Description

### BACKGROUND OF THE INVENTION

### 1. Field of the Invention

The present invention relates to a method of improving the flux resistance of a silicone gel, and a flux-resistant silicone gel composition used in such a method.

### 2. Description of the Prior Art

Gel-like cured products of silicones (organopolysiloxanes) (hereafter referred to as "silicone gels") exhibit excellent electrical insulation properties, excellent stability of electrical properties and superior flexibility. As a result, they are widely used for the potting and sealing of electrical and electronic components. In particular, they are used as coating materials for covering control circuit elements such as power transistors, ICs and capacitors, thereby protecting the elements from thermal and mechanical faults. There are many conventional examples of addition curable organopolysiloxane compositions that can be used for forming these silicone gels. For example, the production of a silicone gel using the addition reaction between an organopolysiloxane that contains vinyl groups bonded to silicon atoms, and an organohydrogenpolysiloxane that contains hydrogen atoms bonded to silicon atoms, in the presence of a platinum-based catalyst, is widely known (see patent references 1 to 7).

However in recent years, in order to prevent environmental pollution, there has been a trend towards minimizing the cleaning of the substrates used for electrical or electronic components, such as IC substrates. Consequently, the chances of direct contact between residual solder flux left on the surface of the substrate and the addition curable silicone composition used for sealing the substrate have increased significantly, which has resulted in problems caused by the solder flux, such as curing inhibition, non-curing at the substrate interface, and a reduction in the hardness of the cured product. Silicone gels have an extremely low cross-linking density, and are therefore particularly prone to curing inhibition caused by solder flux. Countermeasures aimed at improving this curing inhibition of silicone gel compositions caused by solder flux include the techniques disclosed in the patent publications listed below. Patent reference 8 discloses the use of hexamethyldisilazane. Patent reference 9 discloses the use of a silyl ketene acetal. Patent reference 10 discloses the use of an organopolysiloxane comprising a branched structure. Patent reference 11 discloses the use of an organopolysiloxane in which 5 to 30 mol% of the molecular terminal groups are trivinylsilyl groups. However, the use of additives introduces different problems, including degradation of the additives by hydrolysis during storage of the composition, and volatilization of the additives during the heat-curing process. Moreover, the use of a specific organopolysiloxane also raises problems in terms of reduced versatility and economic viability.

Patent reference 12 discloses a silicone gel composition comprising an organopolysiloxane in which an average of 0.15 to 0.35 mol% of the silicon atom-bonded organic groups are alkenyl groups, a non-functional organopolysiloxane, an organohydrogenpolysiloxane comprising an average of 2 silicon atom-bonded hydrogen atoms within each molecule, and an addition reaction catalyst. An example 1 in this patent reference describes a silicone gel composition comprising an organopolysiloxane that contains side chain vinyl groups, an organohydrogenpolysiloxane that contains SiH groups at the molecular terminals, and a non-functional organopolysiloxane. However, the silicone gel obtained upon curing of this composition does not exhibit adequate resistance to solder flux.
[Patent Reference 1] GB 1 373 055 A
[Patent Reference 2] GB 1 582 081 A
[Patent Reference 3] GB 2 004 902 A
[Patent Reference 4]
Japanese Laid-open publication (kokai) No. Sho 56-143241
[Patent Reference 5]
Japanese Laid-open publication (kokai) No. Sho 62-39658
[Patent Reference 6]
Japanese Laid-open publication (kokai) No. Sho 63-35655
[Patent Reference 7] USP 4,771,119
[Patent Reference 8]
Japanese Laid-open publication (kokai) No. Sho 62-290754
[Patent Reference 9]
Japanese Laid-open publication (kokai) No. Sho 63-165455
[Patent Reference 10]
Japanese Laid-open publication (kokai) No. Sho 63-246856
[Patent Reference 11] EP 0 471 475 A2
[Patent Reference 12] USP 5,571,853

### SUMMARY OF THE INVENTION

Accordingly, an object of the present invention is to provide a curable silicone gel composition that suffers no loss in curability even if applied in a location where solder flux exists, and can be used effectively as a protective material or insulating material for an IC or wiring or the like, and also to provide a method of improving the flux resistance of a silicone gel by using such a composition, and a method of forming a flux-resistant silicone gel using such a composition.

As a result of intensive investigation aimed at achieving the above object, the inventors of the present invention discovered that a silicone gel obtained upon curing a composition described below exhibited excellent resistance to solder flux, and they were therefore able to complete the present invention.

In other words, a first aspect of the present invention provides a method of forming a flux-resistant silicone gel that comprises applying a curable silicone gel composition comprising:
(A) 100 parts by mass of a diorganovinylsiloxy-terminated organopolysiloxane represented by a general formula (1) shown below and having a viscosity at 25°C within a range from 50 to 50,000 mPa·s: 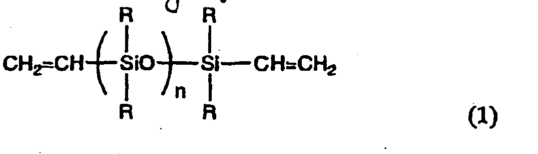 [wherein, R represents an unsubstituted or substituted monovalent hydrocarbon group that contains no aliphatic unsaturated bonds, and n represents a number from 50 to 1,000],
(B) 10 to 200 parts by mass of a non-functional organopolysiloxane, with a viscosity at 25°C within a range from 20 to 10,000 mPa·s and lower than a viscosity at 25°C of the component (A),
(C) an organohydrogenpolysiloxane containing an average of 3 or more hydrogen atoms bonded to silicon atoms within each molecule, in sufficient quantity that the number of mols of hydrogen atoms bonded to silicon atoms within this component (C) is within a range from 0.4 to 3.0 mols per 1 mol of silicon atom-bonded vinyl groups within the organopolysiloxane of the component (A), and
(D) a catalytic quantity of a hydrosilylation reaction catalyst.

in a location where solder flux exists, and it there..

The composition of the present invention is resistant to curing inhibition and is capable of forming a silicone gel with the desired properties, even when applied and cured in a location where residual solder flux exists. As a result, the composition is useful for the potting and sealing of electrical and electronic components, and is particularly useful as a coating material for covering control circuit elements such as power transistors, ICs and capacitors, thereby protecting the elements from thermal and mechanical faults.

### DETAILED DESCRIPTION OF THE PREFERRED EMBODIMENTS

As follows is a more detailed description of the present invention.

### [Curable Silicone Gel Composition]

### - Component (A) -

The organopolysiloxane of the component (A) is a straight-chain diorganopolysiloxane represented by the general formula (1) shown below, wherein the principal chain is formed of repeating diorganosiloxane units and both molecular chain terminals are blocked with diorganovinylsiloxy groups (in this description, the term "organo group" refers to an unsubstituted or substituted monovalent hydrocarbon group that contains no aliphatic unsaturated bonds). In a curable silicone gel composition of the present invention, in order to improve the flux resistance, it is important that the component (A) that functions as the base polymer is a straight-chain siloxane chain structure formed of repeating bifunctional diorganosiloxane units, wherein all of the monofunctional siloxane units that constitute the molecular chain terminals contain a vinyl group bonded to the terminal silicon atom.

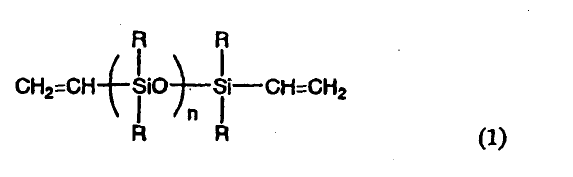

In the general formula (1), R represents an unsubstituted or substituted monovalent hydrocarbon group, excluding aliphatic unsaturated hydrocarbon groups such as alkenyl groups, and specific examples include alkyl groups such as a methyl group, ethyl group, propyl group, butyl group, pentyl group, hexyl group, cyclohexyl group, or heptyl group; aryl groups such as a phenyl group, tolyl group, xylyl group, or naphthyl group; aralkyl goups such as a benzyl group or phenethyl group; and halogenated alkyl groups such as a chloromethyl group, 3-chloropropyl group, or 3,3,3-trifluoropropyl group. n represents a number from 50 to 1,000.

The viscosity at 25°C for this organopolysiloxane is within a range from 50 to 50,000 mPa·s, and is preferably from 100 to 10,000 mPa·s.

### - Component (B) -

The non-functional organopolysiloxane of the component (B) is, for example, a straight-chain or branched non-functional organopolysiloxane, and preferably a straight-chain non-functional organopolysiloxane, represented by an average composition formula (2) shown below:

R¹ₐSiO_{(4-a)/2} (2)

[wherein, R¹ represents an unsubstituted or substituted monovalent hydrocarbon group, excluding aliphatic unsaturated hydrocarbon groups such as alkenyl groups, and a is a number that satisfies 0 < a < 3, and is preferably a number within a range from 1.95 to 2.2, and even more preferably from 1.98 to 2.05]. The term "non-functional" means that this organopolysiloxane contains no functional groups that contribute to the addition reaction between the alkenyl groups within the component (A) and the hydrosilyl groups (SiH groups) within the component (B).

Examples of the group R¹ in the above formula include the same groups as those listed above in relation to the group R. Specific examples of the non-functional organopolysiloxane include diorganopolysiloxanes with both terminals blocked with triorganosiloxy groups (here, the term "organo group" is as defined above for the component (A)), such as dimethylpolysiloxane with both terminals blocked with trimethylsiloxy groups, copolymers of dimethylsiloxane and diphenylsiloxane with both terminals blocked with trimethylsiloxy groups, copolymers of dimethylsiloxane and methylphenylsiloxane with both terminals blocked with trimethylsiloxy groups, and dimethylpolysiloxane with both terminals blocked with dimethylphenylsiloxy groups.

The component (B) functions as a plasticizer within the composition of the present invention, and the hardness of the gel-like cured product generated upon curing the composition can be regulated by adjusting the blend quantity of the component (B). As the blend quantity of the component (B) is increased, the hardness of the resulting gel-like cured product decreases, yielding a softer product. If the blend quantity of the component (B) is too small, then the gel-like cured product cannot be softened adequately, whereas if the blend quantity is too large, the component (B) may exude from the gel-like cured product.

The viscosity of the component (B) at 25°C is within a range from 20 to 10,000 mPa·s, and is preferably from 20 to 8,000 mPa·s, and even more from 50 to 5,000 mPa·s. The viscosity of the component (B) is preferably lower than that of the component (A).

The blend quantity of the component (B) is preferably within a range from 10 to 200 parts by mass, and even more preferably from 50 to 100 parts by mass, per 100 parts by mass of the component (A).

### - Component (C) -

The component (C) is an organohydrogenpolysiloxane containing an average of 3 or more hydrogen atoms bonded to silicon atoms (namely, hydrosilyl groups represented by SiH) within each molecule, and functions as a cross-linking agent within the composition of the present invention.

There are no particular restrictions on the molecular structure of the organohydrogenpolysiloxane of the component (C), and conventionally produced straight-chain, cyclic, branched-chain, or three dimensional network (resin-like) structures can be used, but the organohydrogenpolysiloxane must contain an average of 3 or more hydrogen atoms bonded to silicon atoms (hydrosilyl groups represented by SiH) within each molecule, and preferably contains at least 3 SiH groups within every molecule. The organohydrogenpolysiloxane typically contains an average of 3 to 200, and preferably from 3 to 150, and even more preferably from 4 to 100, SiH groups within each molecule.

Examples of this organohydrogenpolysiloxane include compounds represented by an average composition formula (3) shown below.

R²_{b}H_{c}SiO_{(4-b-C)/2} (3)

In the above formula (3), R² represents an unsubstituted or substituted monovalent hydrocarbon group that contains no aliphatic unsaturated bonds, preferably contains from 1 to 10 carbon atoms, and is bonded to a silicon atom. Specific examples of suitable unsubstituted or substituted monovalent hydrocarbon groups of this group R² include alkyl groups such as a methyl group, ethyl group, propyl group, isopropyl group, butyl group, isobutyl group, tert-butyl group, pentyl group, neopentyl group, hexyl group, cyclohexyl group, octyl group, nonyl group, or decyl group; aryl groups such as a phenyl group, tolyl group, xylyl group, or naphthyl group; aralkyl groups such as a benzyl group, phenylethyl group, or phenylpropyl group; and groups in which a portion of, or all of, the hydrogen atoms in an aforementioned group have been substituted with a halogen atom such as a fluorine, bromine or chlorine atom, such as a chloromethyl group, chloropropyl group, bromoethyl group, or trifluoropropyl group. The unsubstituted or substituted monovalent hydrocarbon group of R² is preferably an alkyl group or aryl group, and is most preferably a methyl group or phenyl group. Furthermore, b is a positive number within a range from 0.7 to 2.1, c is a positive number from 0.001 to 1.0, and b+c is a positive number within a range from 0.8 to 3.0. Moreover, b is preferably within a range from 1.0 to 2.0, c is preferably from 0.01 to 1.0, and b+c is preferably within a range from 1.5 to 2.5.

The average of 3 or more SiH groups within each molecule, which preferably includes at least 3 SiH groups within every molecule, may be located at the molecular chain terminals or at non-terminal positions within the molecular chain, or may also be located at both these positions. Furthermore, the molecular structure of this organohydrogenpolysiloxane may be any one of a straight-chain, cyclic, branched-chain or three dimensional network structure, although the number of silicon atoms within each molecule (namely, the polymerization degree) is typically within a range from 2 to 300, and is preferably from 3 to 150, and even more preferably from 4 to 100. The organohydrogenpolysiloxane is typically a liquid at room temperature (25°C), with a viscosity at 25°C that is typically within a range from 0.1 to 1,000 mPa·s, preferably from 0.5 to 1,000 mPa·s, and even more preferably from 5 to 500 mPa·s.

Provided the organohydrogenpolysiloxane of the component (C) contains an overall average of 3 or more SiH groups per molecule, the component may also include organohydrogenpolysiloxanes that contain only 1 or 2 SiH groups within each molecule.

Specific examples of the organohydrogenpolysiloxane of the component (C) include 1,1,3,3-tetramethyldisiloxane, 1,3,5,7-tetramethylcyclotetrasiloxane, tris(hydrogendimethylsiloxy)methylsilane, tris(hydrogendimethylsiloxy)phenylsilane, methylhydrogencyclopolysiloxane, cyclic copolymers of methylhydrogensiloxane and dimethylsiloxane, methylhydrogenpolysiloxane with both molecular chain terminals blocked with trimethylsiloxy groups, copolymers of dimethylsiloxane and methylhydrogensiloxane with both terminals blocked with trimethylsiloxy groups, dimethylpolysiloxane with both terminals blocked with dimethylhydrogensiloxy groups, copolymers of dimethylsiloxane and methylhydrogensiloxane with both terminals blocked with dimethylhydrogensiloxy groups, copolymers of methylhydrogensiloxane and diphenylsiloxane with both terminals blocked with trimethylsiloxy groups, copolymers of methylhydrogensiloxane, diphenylsiloxane, and dimethylsiloxane with both terminals blocked with trimethylsiloxy groups, copolymers of methylhydrogensiloxane, methylphenylsiloxane, and dimethylsiloxane with both terminals blocked with trimethylsiloxy groups, copolymers of methylhydrogensiloxane, dimethylsiloxane, and diphenylsiloxane with both terminals blocked with dimethylhydrogensiloxy groups, copolymers of methylhydrogensiloxane, dimethylsiloxane, and methylphenylsiloxane with both terminals blocked with dimethylhydrogensiloxy groups, copolymers formed of (CH₃)₂HSiO_{1/2} units, (CH₃)3SiO_{1/2} units, and SiO_{4/2} units, copolymers formed of (CH₃)₂HSiO_{1/2} units and SiO_{4/2} units, and copolymers formed of (CH₃)HSiO_{1/2} units, SiO_{4/2} units, and (C₆H₅)₃SiO_{1/2} units, as well as compounds in which a portion of, or all of, the methyl groups in a compound described above have been substituted, either with other alkyl groups such as ethyl groups or propyl groups, or with phenyl groups or the like.

Of these compounds, organohydrogenpolysiloxanes in which the bifunctional siloxane units of the principal chain are all organohydrogensiloxane units, and in which both terminals are blocked with triorganosiloxy groups (here, an organo group is as defined above for the components (A) and (B), namely, an unsubstituted or substituted monovalent hydrocarbon group that contains no aliphatic unsaturated bonds), such as methylhydrogenpolysiloxane with both terminals blocked with trimethylsiloxy groups, are preferred as they provide favorable improvement in the flux resistance. Namely, organohydrogenpolysiloxanes represented by a general formula: 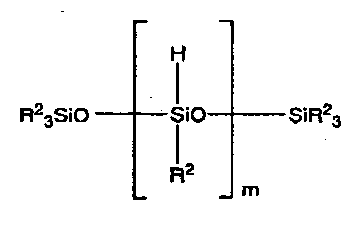 wherein R² groups are as defined above, and m is an average number of 3 to 198, are preferred.

The blend quantity of the component (C) must be sufficient that for each 1 mol of vinyl groups bonded to silicon atoms within the component (A), the number of mols of hydrogen atoms bonded to silicon atoms within the component (C) is within a range from 0.4 to 3.0 mols, preferably from 0.4 to 2.5 mols, and even more preferably from 0.5 to 2.0 mols. If this quantity of hydrogen atoms is less than 0.4 mols, then the composition may not cure satisfactorily. Furthermore, if the quantity of hydrogen atoms exceeds 3.0 mols, then the heat resistance of the obtained cured product may deteriorate significantly.

### - Component (D) -

There are no particular restrictions on the hydrosilylation reaction catalyst of the component (D), provided it accelerates the addition reaction (the hydrosilylation reaction) between the vinyl group-containing organopolysiloxane of the component (A) and the organohydrogenpolysiloxane of the component (C). Conventional hydrosilylation reaction catalysts can be used as the component (D). Specific examples of suitable catalysts include chloroplatinic acid, alcohol-modified chloroplatinic acid, coordination compounds of chloroplatinic acid with olefins, vinylsiloxane or acetylene compounds, tetrakis(triphenylphosphine)palladium and chlorotris(triphenylphosphine)rhodium. Of these, platinum-based compounds are preferred.

The quantity added of the component (D) need only be sufficient to be effective as a hydrosilylation reaction catalyst, and the quantity may be altered in accordance with the desired curing rate. Calculated as the mass of the catalytic metal element relative to the combined mass of the components (A), (B) and (C), the quantity of the catalyst is typically within a range from 0.1 to 1,000 ppm, preferably from 1 to 500 ppm, and even more preferably from 10 to 100 ppm. If this quantity is too large, then the reaction becomes undesirable from an economic viewpoint.

### - Optional Components -

In addition to the components (A) through (D) described above, other optional components may also be added to the composition of the present invention as required, provided such addition does not impair the object of the present invention. For example, any of the conventional retarding agent compounds that exhibit a curing inhibiting effect on the addition reaction catalyst may be used. Specific examples of these compounds include phosphorus-containing compounds such as triphenylphosphine, nitrogen-containing compounds such as tributylamine, tetramethylethylenediamine and benzotriazole, as well as sulfur-containing compounds, acetylene-based compounds, compounds containing 2 or more alkenyl groups, hydroperoxy compounds, and maleic acid derivatives. The degree of the curing retardation effect caused by the retarding agent compound varies considerably depending on the chemical structure of the retarding agent used, and as a result, the quantity added is preferably adjusted to the optimum quantity for that particular retarding agent. Generally, if the quantity added is too small, then the long-term storage stability of the composition at room temperature may be poor, whereas if the quantity added is too large, there is a danger that the curing process may be impaired.

Examples of other optional components include inorganic fillers such as crystalline silica, hollow fillers, silsesquioxanes, fumed titanium dioxide, magnesium oxide, zinc oxide, iron oxide, aluminum hydroxide, magnesium carbonate, calcium carbonate, zinc carbonate, layered mica, carbon black, diatomaceous earth, and glass fiber; and fillers such as those described above that have undergone surface treatment with an organosilicon compound such as an organoalkoxysilane compound, organochlorosilane compound, organosilazane compound, or low molecular weight siloxane compound. Furthermore, silicone rubber powders and silicone resin powders may also be added.

Moreover, heat-resistant additives, pigments, dyes and moldproofing agents and the like may also be added as optional components.

The composition of the present invention forms a silicone gel upon curing. In this description, the term "silicone gel" describes a cured product with a low cross-linking density that comprises an organopolysiloxane as the main component, wherein the (1/4 cone) penetration value (or consistency value) measured in accordance with JIS K2220 is within a range from 20 to 200, preferably from 15 to 200, and even more preferably from 20 to 150. This corresponds with a rubber hardness value measured in accordance with JIS K6301 of zero, indicating that the gel exhibits no effective rubber hardness (and is therefore soft). In this respect, the silicone gel of the present invention differs from so-called silicone rubber cured products (rubber-like elastomers).

The composition of the present invention is cured and converted to a silicone gel either by standing for approximately 24 hours at room temperature (approximately 25°C), or by heating at a temperature of 40 to 150°C.

### [Uses]

The composition of the present invention can be used for application and curing within locations where solder flux exists. In other words, although the trend towards minimizing the cleaning of substrates for electrical or electronic circuits such as IC substrates has increased the chances of residual solder flux existing on the surface of these substrates during semiconductor mounting processes, the composition of the present invention can still be applied and cured within these locations where solder flux exists, thereby forming a coating that seals, insulates and protects the underlying components, as well as absorbing mechanical vibrations and shocks. When used in this manner, the composition of the present invention exhibits excellent flux resistance, suffers no curing inhibition, and is able to seal and cover the substrate in a stable manner, with no loss in the excellent electrical insulation properties, excellent stability of electrical properties and superior flexibility expected of a silicone gel.

As a result, by curing the composition, the level of flux resistance of the silicone gel can be improved, and a silicone gel with excellent flux resistance can be formed.

Examples of the components of the flux include resin acids such as abietic acid, dextropimaric acid and levopimaric acid, as well as amine hydrochlorides and the like.

### EXAMPLES

In the following description, viscosity values refer to values measured at 25°C. Furthermore, SiH/SiVi ratios refer to molar ratios.

### - Example 1-

(a) 100 parts by mass of a dimethylpolysiloxane with both molecular chain terminals blocked with dimethylvinylsiloxy groups, and with a viscosity of 5,000 mPa·s,
(b) 100 parts by mass of a dimethylpolysiloxane with both molecular chain terminals blocked with trimethylsiloxy groups, and with a viscosity of 100 mPa·s,
(c) 0.32 parts by mass of a methylhydrogenpolysiloxane with both molecular chain terminals blocked with trimethylsiloxy groups, and with a viscosity of 250 mPa·s (quantity of silicon atom-bonded hydrogen atoms = 1.08% by mass, number of those hydrogen atoms within each molecule: an average of approximately 45) (the molar ratio of silicon atom-bonded hydrogen atoms within this component (c) relative to silicon atom-bonded vinyl groups within the component (a), namely SiH/SiVi = 0.57),
(d) 0.1 parts by mass of 1-ethynylcyclohexanol, and
(e) a complex of chloroplatinic acid and divinyltetramethyldisiloxane, in sufficient quantity to provide a mass of platinum metal, relative to the combined mass of all the components, of 5 ppm were mixed together to prepare a composition A.

### -- Test for Evaluating Flux Resistance --

First, the prepared composition was cured by heating at 120°C for 60 minutes, thus forming a transparent gel product. The hardness (penetration value) of this gel product was measured using a penetrometer prescribed in JIS K2220 (a 1/4 scale cone).

Subsequently, a flux was prepared by dissolving abietic acid in toluene to form a 10% solution. This solution was added to the prepared composition in sufficient quantity that the concentration of abietic acid within the composition was 300 ppm, the composition was cured by heating at 120°C for 60 minutes, and the hardness (penetration value) of the gel product was measured using a penetrometer prescribed in JIS K2220 (a 1/4 scale cone).

The results are shown in Table 1.

### - Example 2 -

With the exceptions of altering the quantity of the component (b) to 50 parts by mass, and altering the quantity of the component (c) to 0.34 parts by mass (SiH/SiVi = 0.62), a composition B was prepared in the same manner as the example 1.

The flux resistance of the prepared composition was evaluated in the same manner as the example 1. The results are shown in Table 1.

### - Comparative Example 1 -

With the exceptions of not adding the component (b), and altering the quantity of the component (c) to 0.22 parts by mass (SiH/SiVi = 0.4), a composition C was prepared in the same manner as the example 1.

The flux resistance of the prepared composition was evaluated in the same manner as the example 1. The results are shown in Table 1.

### - Comparative Example 2 -

100 parts by mass of a dimethylpolysiloxane with both molecular chain terminals blocked with trimethylsiloxy groups and with a viscosity of 1,000 mPa·s, in which 99.6 mol% of the diorganosiloxane units that constitute the principal chain are dimethylsiloxane units and the remaining 0.4 mol% are vinylmethylsiloxane units,
85 parts by mass of a dimethylpolysiloxane with both molecular chain terminals blocked with trimethylsiloxy groups, and with a viscosity of 1,000 mPa·s,
4.86 parts by mass of a dimethylpolysiloxane with silicon atom-bonded hydrogen atoms at both molecular chain terminals and with a viscosity at 25°C of 18 mPa·s (quantity of silicon atom-bonded hydrogen atoms = 0.13% by mass, number of those hydrogen atoms within each molecule: an average of 2) (SiH/SiVi = 1.15),
0.1 parts by mass of 1-ethynylcyclohexanol, and
a complex of chloroplatinic acid and divinyltetramethyldisiloxane, in sufficient quantity to provide a mass of platinum metal, relative to the combined mass of all the components, of 5 ppm
were mixed together to prepare a composition D.

The flux resistance of the prepared composition was evaluated in the same manner as the example 1, The results are shown in Table 1.

### - Comparative Example 3 -

100 parts by mass of a dimethylpolysiloxane with a viscosity of 800 mPa·s, in which of the two monofunctional siloxy units at the molecular chain terminals, an average of 0.58 units are blocked with dimethylvinylsiloxy groups and the remaining average of 1.42 units are blocked with trimethylsiloxy groups,
25 parts by mass of a dimethylpolysiloxane with both molecular chain terminals blocked with trimethylsiloxy groups, and with a viscosity of 1,000 mPa·s,
0.7 parts by mass of a methylhydrogenpolysiloxane with both molecular chain terminals blocked with trimethylsiloxy goups and with a viscosity of 100 mPa·s (quantity of silicon atom-bonded hydrogen atoms = 0.51% by mass, number of those hydrogen atoms within each molecule: an average of approximately 16) (the molar ratio of silicon atom-bonded hydrogen atoms within this component relative to the above vinyl groups, namely SiH/SiVi = 0.94),
0.1 parts by mass of 1-ethynylcyclohexanol, and
a complex of chloroplatinic acid and divinyltetramethyldisiloxane, in sufficient quantity to provide a mass of platinum metal, relative to the combined mass of all the components, of 5 ppm
were mixed together to prepare a composition E.

The flux resistance of the prepared composition was evaluated in the same manner as the example 1. The results are shown in Table 1.

**[Table 1]**

| | Example 1 | Example 2 | Comparative example 1 | Comparative example 2 | Comparative example 3 |
|---|---|---|---|---|---|
| No flux added | 117 | 83 | 103 | 115 | 115 |
| 300 ppm of flux added | 120 | 86 | 134 | 148 | Measurement impossible (liquid)* |

| | | | | | |
|---|---|---|---|---|---|
| (*) As a result of a poor curing, the composition did not cure, but remained a liquid, meaning measurement was impossible. | | | | | |

## Claims

1. A method of forming a flux-resistant silicone gel, comprising applying a curable silicone gel composition comprising:
(A) 100 parts by mass of a diorganovinylsiloxy-terminated organopolysiloxane represented by the general formula (1) shown below and having a viscosity at 25°C within the range from 50 to 50.000mPa.s: 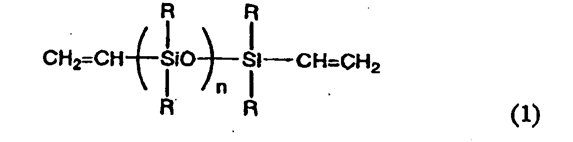 wherein R represents an unsubstituted or substituted monovalent hydrocarbon group that contains no aliphatic unsaturated bonds, and n represents a number from 50 to 1,000,
(B) 10 to 200 parts by mass of a non-functional organopolysiloxane, with a viscosity at 25°C within the range from 20 to 10,000 mPa.s and lover than the viscosity at 25°C of the component (A),
(C) an organohydrogenpolysiloxane containing an average of 3 or more hydrogen atoms bonded to silicon atoms within each molecule, in sufficient quantity that the number of mols of hydrogen atoms bonded to silicon atoms within this component (C) is within the range from 0.4 to 3.0 mols per 1 mol of silicon atom-bonded vinyl groups within said organopolysiloxane of said component (A), and
(D) an effective quantity of a hydrosilylation reaction catalyst, in a location where solder flux exists, and curing it there.

2. A method of forming a silicone gel coating on a substrate, comprising applying the composition defined in claim 1 to a substrate on which solder flux exists, and curing said composition to form a silicone gel coating on the substrate.

3. The method according to any one of the preceding claims, wherein said organopolysiloxane of said component (B) is a straight-chain or branched non-functional organopolysiloxane represented by an average composition formula (2) shown below:
R¹ₐSiO_{(4-a)/2} (2)
wherein R¹ represents an unsubstituted or substituted monovalent hydrocarbon group excluding aliphatic unsaturated hydrocarbon groups, and a is a number that satisfies 0 < a < 3.

4. The method according to any one of the preceding claims, wherein said organohydrogenpolysiloxane of said component (C) contains an average of 3 to 200 hydrogen atoms bonded to silicon atoms within each molecule.

5. The method according to claim any one of the preceding claims, wherein said organohydrogenpolysiloxane of said component (C) has a viscosity at 25°C within the range from 0.1 to 1,000 mPa·s.

6. The method according to claim 5, wherein said organohydrogenpolysiloxane of said component (C) is represented by the general formula shown below: 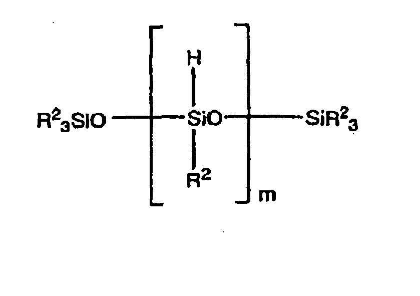 wherein, R² groups each represent an unsubstituted or substituted monovalent hydrocarbon group that contains no aliphatic unsaturated bonds, and m is an average number of 3 to 198.

7. A covered control circuit element comprising a control circuit element where residual solder flux exists, and a silicone gel covering said control circuit element, wherein said silicone gel is formed by applying and curing a curable silicone gel composition as defined in claim 1.

8. Use of a curable silicone gel composition as defined in claim 1 for formation of a silicone gel covering a control circuit element where residual solder flux exists.

9. Use of a curable silicone gel composition as defined in claim 1 for forming a silicone gel in a location where residual solder exists.

10. The use of claim 9, wherein the silicone gel is a coating material for covering a control circuit element selected from the group consisting of power transistors, ICs and capacitors.

## Patentansprüche

1. Verfahren zum Bilden eines schweißbeständigen bzw. Lötmittel-beständigen Silikongels, umfassend das Aufbringen einer härtbaren Silikongelzusammensetzung, umfassend
(A) 100 Masse-Teile eines Diorganovinylsiloxy-terminierten Organopolysiloxans, dargestellt durch die allgemeine Formel (1), wie nachstehend gezeigt, und mit einer Viskosität bei 25°C innerhalb des Bereichs von 50 bis 50.000 mPa·s: 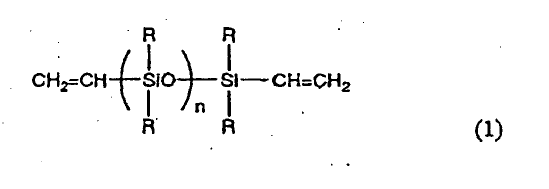 worin R eine unsubstituierte oder substituierte einwertige Kohlenwasserstoffgruppe, die keine aliphatischen ungesättigten Bindungen enthält, darstellt, und n eine Zahl von 50 bis 1.000 darstellt,
(B) 10 bis 200 Masse-Teile eines nicht-funktionalen Organopolysiloxans, mit einer Viskosität bei 25°C innerhalb des Bereichs von 20 bis 10.000 mPa·s und geringer als die Viskosität bei 25°C der Komponente (A),
(C) ein Organohydrogenpolysiloxan, enthaltend einen Durchschnitt von 3 oder mehr Wasserstoffatomen, gebunden an Siliziumatome innerhalb jedes Moleküls, in einer ausreichenden Menge, daß die Molzahl an Wasserstoffatomen, gebunden an Siliziumatome, innerhalb dieser Komponente (C) innerhalb des Bereichs von 0,4 bis 3,0 Mol pro 1 Mol Siliziumatom-gebundener Vinylgruppen innerhalb des Organopolysiloxans der Komponente (A) ist, und
(D) eine wirksame Menge eines Hydrosilylierungs-Reaktionskatalysators, an einer Stelle, an welcher das Lötflußmittel existiert, und dort Härten dieser.

2. Verfahren zum Bilden einer Silikongelbeschichtung auf einem Substrat, umfassend das Aufbringen der Zusammensetzung, wie in Anspruch 1 definiert, auf ein Substrat, auf welchem Lötflußmittel existiert, und Härten der Zusammensetzung unter Bildung einer Silikongelbeschichtung auf dem Substrat.

3. Verfahren gemäß einem der vorhergehenden Ansprüche, wobei das Organopolysiloxan der Komponente (B) ein geradkettiges oder verzweigtkettiges nicht-funktionales Organopolysiloxan, dargestellt durch eine durchschnittliche Zusammensetzungsformel (2), wie nachstehend gezeigt, ist:
R¹ₐSiO_{(4-a)/2} (2)
worin R¹ eine unsubstituierte oder substituierte einwertige Kohlenwasserstoffgruppe darstellt, ausgeschlossen aliphatische ungesättigte Kohlenwasserstoffgruppen, und a eine Zahl ist, die 0 < a < 3 genügt.

4. Verfahren gemäß einem der vorhergehenden Ansprüche, wobei das Organohydrogenpolysiloxan der Komponente (C) einen Durchschnitt von 3 bis 200 Wasserstoffatomen, gebunden an Siliziumatome, innerhalb jedes Moleküls enthält.

5. Verfahren gemäß einem der vorhergehenden Ansprüche, wobei das Organohydrogenpolysiloxan der Komponente (C) eine Viskosität bei 25°C, innerhalb des Bereichs von 0,1 bis 1000 mPa·s, aufweist.

6. Verfahren gemäß Anspruch 5, wobei das Organohydrogenpolysiloxan der Komponente (C) durch die allgemeine Formel, wie nachstehend gezeigt, dargestellt wird: 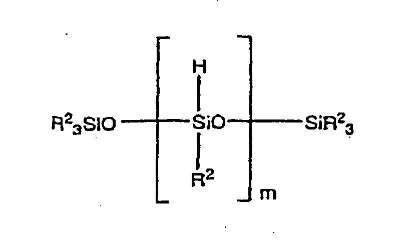 worin die Gruppen R² jeweils eine unsubstituierte oder substituierte einwertige Kohlenwasserstoffgruppe darstellen, die keine aliphatischen ungesättigten Bindungen enthalten, und m eine durchschnittliche Zahl von 3 bis 198 ist.

7. Bedecktes Steuerkreiselement, umfassend ein Steuerkreiselement, in welchem restliches Lötflußmittel existiert, und ein Silikongel, welches das Steuerkreiselement bedeckt, wobei das Silikongel durch Aufbringen und Härten einer härtbaren Silikongelzusammensetzung, wie in Anspruch 1 definiert, gebildet wird.

8. Verwendung einer härtbaren Silikongelzusammensetzung, wie in Anspruch 1 definiert, zur Bildung einer Silikongelbedeckung eines Schaltkreiselements, in welchem restliches Lötflußmittel existiert.

9. Verwendung einer härtbaren Silikongelzusammensetzung, wie in Anspruch 1 definiert, zum Bilden eines Silikongels an einer Stelle, an welcher restliches Lötmittel existiert.

10. Verwendung gemäß Anspruch 9, wobei das Silikongel ein Beschichtungsmaterial zum Bedecken eines Steuerkreiselementes, ausgewählt aus der Gruppe, bestehend aus Leistungstransistoren, ICs und Kondensatoren, ist.

## Revendications

1. Procédé de formation d'un gel de silicone résistant au flux, comprenant l'application d'une composition de gel de silicone durcissable comprenant:
(A) 100 parties en masse d'un organopolysiloxane à terminaison diorganovinylsiloxy représenté par la formule générale (1) présentée ci-dessous et ayant une viscosité à 25°C comprise dans l'intervalle de 50 à 50 000 mPa.s: 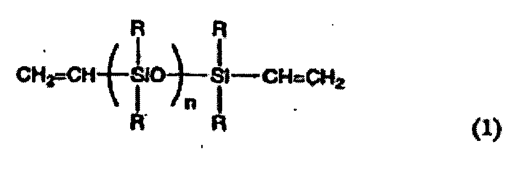 dans laquelle R représente un groupe hydrocarboné monovalent non substitué ou substitué qui ne contient pas de liaisons insaturées aliphatiques, et n représente un nombre allant de 50 à 1000,
(B) 10 à 20 parties en masse d'un organopolysiloxane non fonctionnel ayant une viscosité à 25°C comprise dans l'intervalle de 20 à 10 000 mPa.s et inférieure à la viscosité à 25°C du composant (A),
(C) un organohydrogénopolysiloxane contenant en moyenne 3 atomes d'hydrogène ou plus, liés aux atomes de silicium au sein de chaque molécule, en quantité suffisante pour que le nombre de moles d'atomes d'hydrogène liés aux atomes de silicium dans ce composant (C) soit compris dans l'intervalle de 0,4 à 3,0 moles pour 1 mole de groupes vinyle liés aux atomes de silicium au sein dudit organopolysiloxane dudit composant (A), et
(D) une quantité efficace d'un catalyseur de réaction d'hydrosilylation, à un endroit où se trouve un flux de soudure, et son durcissement à cet endroit.

2. Procédé de formation d'une couche de gel de silicone sur un substrat, comprenant l'application de la composition définie dans la revendication 1 sur un substrat sur lequel se trouve un flux de soudure, et le durcissement de ladite composition pour former une couche de gel de silicone sur le substrat.

3. Procédé selon l'une quelconque des revendications précédentes, dans lequel ledit organopolysiloxane dudit composant (B) est un organopolysiloxane non fonctionnel à chaîne linéaire ou ramifié représenté par une formule de composition moyenne (2) présentée ci-dessous:
R¹ₐSiO_{(4-a)/2} (2)
dans laquelle R¹ représente un groupe hydrocarboné monovalent non substitué ou substitué à l'exclusion des groupes hydrocarbonés aliphatiques insaturés, et a est un nombre qui répond à 0<a<3.

4. Procédé selon l'une quelconque des revendications précédentes, dans lequel ledit organohydrogénopolysiloxane dudit composant (C) contient une moyenne de 3 à 200 atomes d'hydrogène liés aux atomes de silicium au sein de chaque molécule.

5. Procédé selon l'une quelconque des revendications précédentes, dans lequel ledit organohydrogénopolysiloxane dudit composant (C) a une viscosité à 25°C comprise dans l'intervalle de 0,1 à 1000 mPa.s.

6. Procédé selon la revendication 5, dans lequel ledit organohydrogénopolysiloxane dudit composant (C) est représenté par la formule générale présentée ci-dessous: 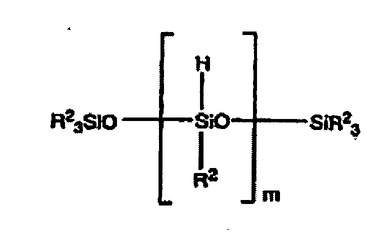 dans laquelle les groupes R² représentent chacun un groupe hydrocarboné monovalent non substitué ou substitué qui ne contient pas de liaisons insaturées aliphatiques, et m est un nombre moyen de 3 à 198.

7. Elément de circuit de commande recouvert comprenant un élément de circuit de commande où un flux de soudure résiduel est présent, et un gel de silicone recouvrant l'élément de circuit de commande, dans lequel ledit gel de silicone est formé par application et durcissement d'une composition de gel de silicone durcissable telle que définie dans la revendication 1.

8. Utilisation d'une composition de gel de silicone durcissable telle que définie dans la revendication 1 pour la formation d'un gel de silicone recouvrant un élément de circuit de commande où un flux de soudure résiduel est présent.

9. Utilisation d'une composition de gel de silicone durcissable telle que définie dans la revendication 1 pour la formation d'un gel de silicone à un endroit où se trouve une soudure résiduelle.

10. Utilisation selon la revendication 9, où le gel de silicone est un matériau de revêtement pour recouvrir un élément de circuit de commande choisi dans le groupe constitué par les transistors de puissance, les circuits intégrés et les condensateurs.
